Europäisches Patentamt

European Patent Office

Office européen des brevets

(11) Numéro de publication: **0 273 793 B1**

# FASCICULE DE BREVET EUROPEEN

(45) Date de publication de fascicule du brevet:
**16.10.91**

(51) Int. Cl.⁵: **H03H 7/01**, H03H 7/12

(21) Numéro de dépôt: **87402672.7**

(22) Date de dépôt: **26.11.87**

(54) **Réjecteur de bande à grande sélectivité, et utilisation d'un tel réjecteur.**

(30) Priorité: **28.11.86 FR 8616670**

(43) Date de publication de la demande:
**06.07.88 Bulletin 88/27**

(45) Mention de la délivrance du brevet:
**16.10.91 Bulletin 91/42**

(84) Etats contractants désignés:
**DE GB IT**

(56) Documents cités:
**EP-A- 0 255 195**
**DE-B- 1 228 322**
**GB-A- 2 100 080**

(73) Titulaire: **THOMSON-CSF**
**51, Esplanade du Général de Gaulle**
**F-92800 Puteaux(FR)**

(72) Inventeur: **Balin, Jean-Claude**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

**Description**

L'invention concerne un réjecteur de bande à grande sélectivité, pour transmettre toutes les fréquences d'un domaine de fréquences déterminé et rejeter une étroite bande de fréquences centrée sur une fréquence déterminée $F_o$. Un tel réjecteur est utilisé par exemple à l'entrée d'un récepteur radio pour éliminer le brouillage constitué par la réception, sur une fréquence fixe, d'un émetteur situé à proximité du récepteur considéré.

Les récepteurs radio comportent un étage de présélection à haute fréquence mais celui-ci a une sélectivité de l'ordre de ± 10 % autour de la fréquence de réception. Cette sélectivité n'est donc pas très bonne, et il est difficile de l'améliorer dans des récepteurs couvrant de très larges gammes, par exemple 20 à 1350 MHz, parce que l'accord est réalisé au moyen de plusieurs inductances ou lignes commutées automatiquement et au moyen de diodes à capacité variable, ne permettant pas de réaliser des circuits résonnants à très haute sélectivité. Dans ces conditions, un émetteur situé à faible distance du récepteur et ayant une fréquence peu différente de la fréquence de réception, provoque des phénomènes de saturation ou d'intermodulation avec les signaux utiles, ce qui perturbe fortement la réception de ces signaux utiles.

Il est connu de réaliser des réjecteurs de bande au moyen d'inductances et de capacités localisées ou au moyen de lignes, mais il n'est pas possible d'obtenir une sélectivité suffisante pour des fréquences dépassant quelques dizaines de mégahertz. Une sélectivité insuffisante du réjecteur empêche la réception dans une plage de fréquences de largeur non négligeable. Il est connu aussi de réaliser des filtres réjecteurs de bande au moyen de résonateurs à quartz ou au tantalate de lithium, mais de tels réjecteurs présentent un taux d'intermodulation médiocre, ce qui est particulièrement gênant dans cette application. En outre, ils présentent de nombreuses fréquences de résonance parasite en dehors de la fréquence d'accord, ce qui est nuisible à la réception des fréquences utiles. Enfin, ces réjecteurs sont difficilement associables en série, pour rejeter plusieurs fréquences gênantes, à cause de la mauvaise adaptation d'impédance de ces dispositifs sur le domaine de fréquences considéré. Le but de l'invention est de remédier à ces inconvénients par des moyens simples. L'objet de l'invention est un réjecteur de bande comportant essentiellement deux filtres passe-bande classiques. Ceux-ci présentent l'intérêt de pouvoir être réalisés avec une grande sélectivité même pour des fréquences supérieures à quelques dizaines de mégahertz, contrairement aux filtres réjecteurs de bande classiques.

Selon l'invention, un réjecteur de bande à grande sélectivité, pour transmettre toutes les fréquences d'un domaine de fréquences déterminé et rejeter une étroite bande centrée sur une fréquence $F_o$ déterminée, est caractérisé en ce qu'il comporte :

- un coupleur dit coupleur quadrature à -3dB, ayant un premier accès constituant l'entrée du réjecteur, un second accès, un troisième accès, et un quatrième accès constituant une sortie du réjecteur, et tels que si un signal est appliqué au premier accès, le second et le troisième accès fournissent respectivement deux signaux d'amplitudes égales et en quadrature, et le quatrième accès fournit un signal d'amplitude nulle si et seulement si le second et le troisième accès sont chargés par des impédances adaptées ;
- un premier et un second filtre passe-bande identiques, à haute sélectivité, accordés sur la fréquence $F_o$, ayant chacun une entrée dont l'impédance est adaptée à celle du coupleur pour la fréquence $F_o$, étant couplés respectivement au second et au troisième accès du coupleur en quadrature, et ayant chacun une sortie chargée par une impédance adaptée pour la fréquence $F_o$.

L'invention sera mieux comprise et d'autres détails apparaîtront à l'aide de la description ci-dessous et des figures l'accompagnant :
- la figure 1 représente un réjecteur de bande, classique, à constantes localisées ;
- la figure 2 représente un circuit passe-bande, classique, à constantes localisées ;
- la figure 3 représente le schéma synoptique d'un premier exemple de réalisation du réjecteur de bande, selon l'invention ;
- la figure 6 représente un second exemple de réalisation du réjecteur de bande selon l'invention ;

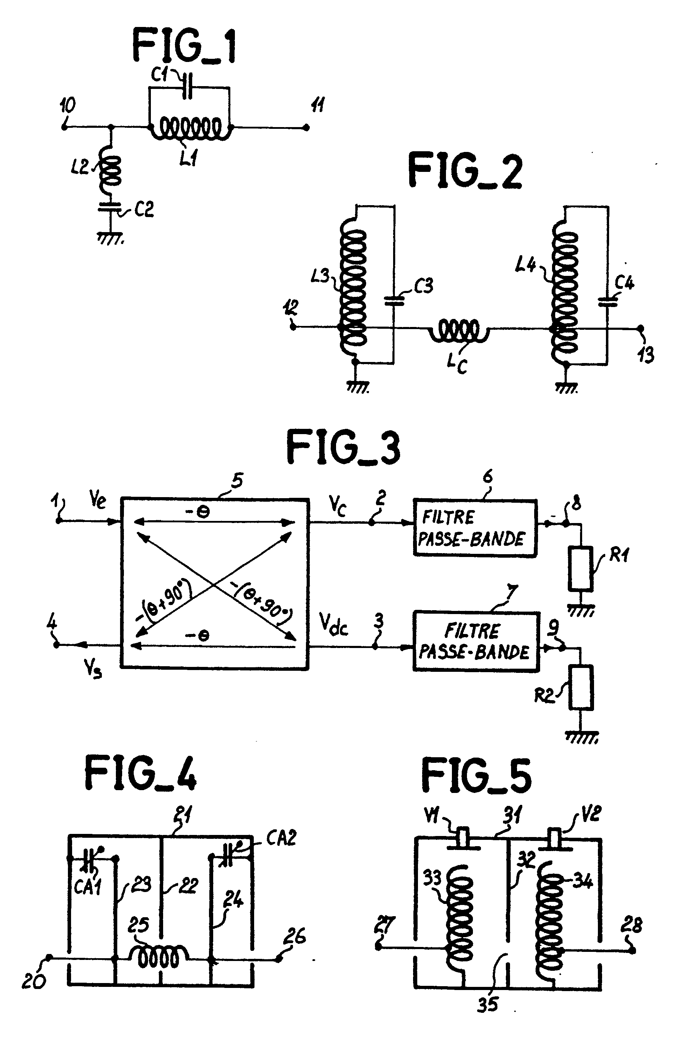

- Les figures 4, 5, 7, 8, 9, 10 représentent des schémas synoptiques de différentes parties de ces deux exemples de réalisation ;

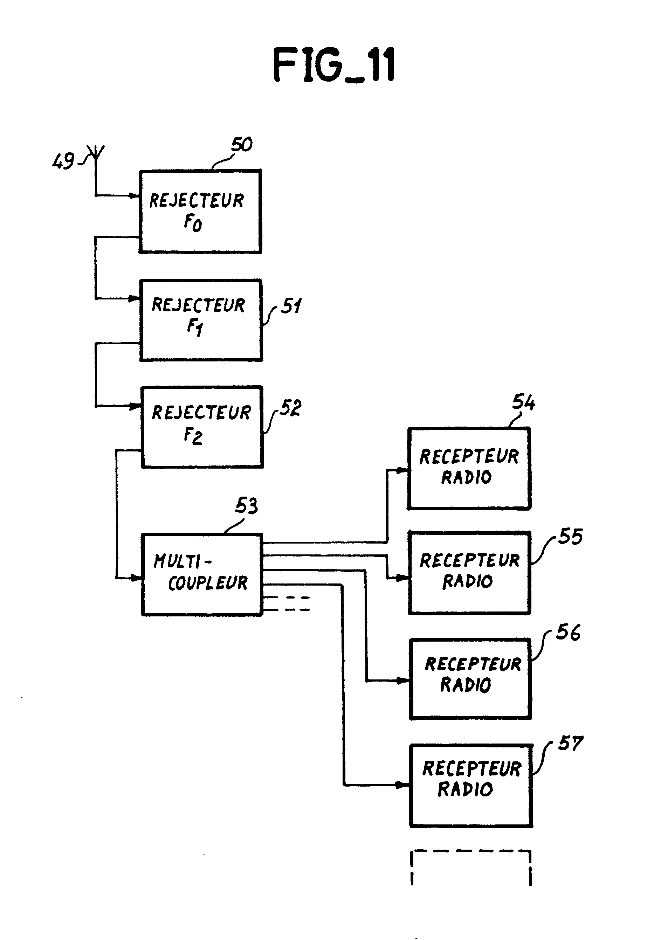

- la figure 11 représente un schéma synoptique d'une station de réception radio dans laquelle plusieurs réjecteurs de bande, selon l'invention, sont utilisés.

La figure 1 représente le schéma d'un circuit réjecteur de bande, classique, à constantes localisées et la figure 2 représente le schéma d'un circuit passe-bande, classique, à constantes localisées, dans le but de comparer leur sélectivité et leurs possibilités de réalisation. Sur la figure 1, le circuit réjecteur de bande comporte une borne d'entrée 10 et une borne de sortie 11 entre lesquelles est intercalé un circuit antirésonnant constitué d'une inductance L1 et d'une capacité C1 en parallèle. Un autre circuit résonnant,

EP 0 273 793 B1

constitué d'une inductance L2 et d'une capacité C2 en série relie la borne d'entrée 10 à un potentiel de référence. Le calcul montre que si un coefficient de surtension en charge, Q, est souhaité pour chacun des deux circuits résonnants, il est nécessaire que la valeur de l'inductance L2 soit $Q^2$ fois supérieure à la valeur de l'inductance L1. Il est donc impossible de réaliser un tel circuit pour obtenir un coefficient de surtension en charge supérieur ou égal à 100.

Sur la figure 2, le circuit passe-bande comporte une borne d'entrée 12 et une borne de sortie 13 reliées respectivement à une prise intermédiaire sur une inductance L3 et à une prise intermédiaire sur une inductance L4, ces prises intermédiaires étant reliées entre elles par une inductance $L_c$. Une capacité C3 est reliée en parallèle sur l'inductance L3 pour constituer un circuit antirésonnant et une capacité C4 est reliée en parallèle sur l'inductance L4 pour constituer un autre circuit antirésonnant. Un point commun à l'inductance L3 et à la capacité C3 est relié à un potentiel de référence. Un point commun à l'inductance L4 et à la capacité C4 est relié au même potentiel de référence.

Les valeurs L3 et L4 sont égales, de même les valeurs C3 et C4 sont égales. Ces valeurs peuvent être choisies librement pour obtenir le coefficient de surtension souhaité à la fréquence d'accord. L'impédance souhaitée à l'entrée de ce circuit passe-bande et l'impédance souhaitée à la sortie de ce circuit sont déterminées par la position des prises intermédiaires. L'effet de transformation de ces prises intermédiaires permet de réduire l'amortissement de ces circuits résonnants et par conséquent permet d'obtenir une haute sélectivité. Le choix de la valeur de la self de couplage $L_c$ détermine aussi la valeur du coefficient de surtension du filtre passe-bande. Un tel filtre passe-bande convient pour des fréquences inférieures ou égales à 100 MHz. Un filtre passe-bande réalisé au moyen de lignes permet de manière analogue d'obtenir une haute sélectivité, pour des fréquences supérieures à 100 MHz.

La figure 3 représente le schéma synoptique d'un premier exemple de réalisation du réjecteur de bande selon l'invention. Il comporte : une borne d'entrée 1 ; une borne de sortie 4 ; un coupleur 5, dit coupleur quadrature, à -3 dB ; un premier filtre et un second filtre passe-bande, 6 et 7 ; et deux résistances pures, R1 et R2. Quel que soit son mode de réalisation, un coupleur quadrature -3dB comporte quatre accès tels que si un signal est appliqué à un premier accès, un second et un troisième accès fournissent respectivement deux signaux d'amplitude égale et en quadrature, car ils sont déphasés respectivement de $-\theta$ et de $-(\theta + 90°)$ par rapport au signal appliqué sur le premier accès ; et un quatrième accès fournit un signal d'amplitude nulle si et seulement si le second et le troisième accès sont chargés par des impédances adaptées. Réciproquement, si un signal est appliqué au quatrième accès, le second et le troisième accès fournissent respectivement deux signaux d'amplitude égale et en quadrature, car ils sont déphasés respectivement de $-(\theta + 90°)$ et de $-\theta$ par rapport au signal appliqué sur le quatrième accès ; et le premier accès fournit un signal nul, si et seulement si le second et le troisième accès sont chargés par des impédances adaptées.

Dans le réjecteur de bande selon l'invention, le coupleur 5 possède un premier accès relié à la borne d'entrée 1 du réjecteur et recevant un signal à filtrer, d'amplitude $V_e$. Il possède un second accès relié à une borne de sortie 2 et fournissant un premier signal de sortie, d'amplitude $V_c$. Il comporte un troisième accès relié à une borne de sortie 3 et fournissant un second signal de sortie, d'amplitude $V_{dc}$ et en quadrature avec le premier signal de sortie. Il comporte un quatrième accès relié à la borne de sortie 4 du réjecteur de bande et fournissant un troisième signal de sortie, dont l'amplitude $V_s$ est nulle pour un signal d'entrée de fréquence $F_o$ qui est la fréquence à rejeter, et dont l'amplitude $V'_s$ est sensiblement égale à l'amplitude $V_e$ du signal d'entrée pour toutes les fréquences du domaine considéré, à l'exception de la fréquence $F_o$.

Les bornes de sorties 2 et 3 du coupleur 5 sont reliées respectivement à une entrée du filtre passe-bande 6 et à une entrée du filtre passe-bande 7. Ces derniers ont respectivement des bornes de sorties 8 et 9 chargées respectivement par les résistances R1 et R2. Tous les potentiels de ce dispositif sont considérés par rapport à un potentiel de référence commun. Les filtres passe-bandes 6 et 7 sont identiques et sont accordés sur la fréquence à rejeter, $F_o$, et ont un coefficient de surtension correspondant à la largeur de la bande de fréquence à rejeter autour de la fréquence $F_o$. Ils sont réalisés de telle façon que leur impédance d'entrée soit adaptée à celle du coupleur 5 pour la fréquence $F_o$ et les valeurs des résistances R1 et R2 sont égales et choisies de manière à être adaptées à l'impédance de sortie des filtres 6 et 7 pour la fréquence $F_o$.

L'impédance de la source du signal d'entrée est supposée adaptée à l'impédance d'entrée du coupleur 5. Dans ces conditions, un calcul montre que le coefficient de réflexion sur le quatrième accès est égal à :

$$\Gamma 4 = \tfrac{1}{2}(\Gamma_2 - \Gamma_3)$$

où $\Gamma_2$ et $\Gamma_3$ sont les coefficients de réflexion des filtres passe-bandes 6 et 7. Puisque ces deux filtres sont strictement identiques leurs coefficients de réflexion sont identiques pour toutes les fréquences du domaine et par conséquent le coefficient de réflexion $\Gamma_4$ est nul pour toutes les fréquences, donc l'accès 4 est adapté pour toutes les fréquences. De même, un calcul montre que le coefficient de réflexion $\Gamma_1$ sur le premier accès du coupleur 5 a pour valeur :

$$\Gamma_1 = \tfrac{1}{2}(\Gamma_3 - \Gamma_2)$$

Par conséquent le coefficient de réflexion à l'entrée du réjecteur est nul pour toutes les fréquences du domaine. L'entrée du réjecteur est donc adaptée pour toutes les fréquences du domaine. Un calcul montre que pour des filtres passe-bandes du type Butterworth, le rapport de la puissance de sortie $P_{s4}$, à la puissance d'entrée, $P_e$, du réjecteur est égale à :

$$\frac{P_{S4}}{P_e} = \frac{1}{a'^2} \times \frac{\left[ (\frac{F}{F_o} - \frac{F_o}{F}) / (\frac{F_c}{F_o} - \frac{F_o}{F_c}) \right]^{2n}}{1 + \left[ (\frac{F}{F_o} - \frac{F_o}{F}) / (\frac{F_c}{F_o} - \frac{F_o}{F_c}) \right]^{2n}}$$

où $a'$ est le coefficient de perte d'insertion du coupleur 5 ; où $F$ est la fréquence du signal d'entrée du réjecteur ; où $F_o$ est la fréquence d'accord des filtres passe-bandes 5 ; où $F_c$ est la fréquence de coupure à 3dB des filtres passe-bandes 5 et 6 ; et où $n$ est le nombre de pôles des filtres passe-bandes 5 et 6. En pratique, dans la plupart des cas deux pôles suffisent et un filtre de type Tchebytcheff peut aussi être utilisé, à condition que sa courbe de réponse en amplitude ait une faible ondulation dans la bande passante, par exemple de l'ordre de 0,2 dB, pour éviter un désadaptation des filtres passe-bandes, cette désadaptation se traduisant par un signal de sortie non nul à la sortie du réjecteur à la fréquence $F_o$.

Pour des fréquences inférieures à 100 MHz, les filtres passe-bandes 6 et 7 peuvent être réalisés selon le schéma représenté à la figure 2, avec des constantes localisées. Pour des fréquences supérieures, les filtres passe-bandes 6 et 7 peuvent être réalisés conformément aux exemples de réalisation représentés sur les figures 4 et 5.

Sur la figure 4, un filtre passe-bande comporte un boîtier métallique 21 divisé en deux compartiments égaux par une cloison métallique 22 percée d'un trou dans lequel passe une inductance de couplage 25. Un premier compartiment contient une ligne quart-d'onde raccourcie, 23, ayant une extrémité reliée au boîtier 21 et une autre extrémité chargée par une capacité ajustable CA1. Une prise intermédiaire est reliée d'une part à une première extrémité de la self de couplage 25 et d'autre part à une borne d'entrée 20. Le second compartiment contient une ligne quartd'onde raccourcie, 24, ayant une première extrémité reliée au boîtier 21 et une seconde extrémité chargée par une capacité ajustable CA2. Elle comporte aussi une prise intermédiaire reliée d'une part à une seconde extrémité de la self de couplage 25 et d'autre part à une borne de sortie 26. La self de couplage 25 peut être remplacée par une capacité de couplage.

Ces lignes 23 et 24 peuvent être réalisées dans l'air ou sur un support, par des techniques classiques telles que les techniques appelées microstrips ou strip lines, sous la forme de conducteurs plats collés sur un substrat isolant. L'encombrement de ces lignes est alors réduit du fait de la constante diélectrique de substrat, qui est supérieure à la constante diélectrique de l'air. Une autre façon de réduire l'encombrement de ces lignes consiste à les réaliser sous la forme d'hélices enroulées sur deux mandrins.

La figure 5 représente le schéma synoptique d'un filtre passe-bande réalisé selon cette technique. Il comporte un boîtier métallique 31 divisé en deux compartiments égaux, par une cloison métallique 32 comportant un iris de couplage 35. Un premier compartiment contient une ligne en hélice 33, dont une première extrémité est reliée au boîtier 31 et dont une seconde extrémité est libre. Une vis de réglage V1 est placée en vis-à-vis de cette extrémité pour constituer une capacité ajustable permettant d'accorder la résonance de cette ligne en hélice. Une prise intermédiaire sur cette ligne est reliée à une borne d'entrée 27. Le second compartiment du boîtier 31 contient une ligne en hélice 34 dont une première extrémité est reliée au boîtier 31 et dont une seconde extrémité est libre. Une vis de réglage V2 est située vis-à-vis de cette seconde extrémité et constitue une capacité ajustable permettant de régler la fréquence d'accord de cette seconde ligne 34. Une prise intermédiaire sur cette ligne 34 est reliée à une borne de sortie 28. D'autres modes de couplage, capacitifs ou inductifs peuvent être prévus. Avec de tels filtres passe-bandes, le réjecteur selon l'invention permet d'obtenir, par exemple, une sélectivité de ± 0,3 % au environ de 100 MHz alors qu'un bon réjecteur classique procure une sélectivité de ± 2 ou 3 %.

Dans le cas où les filtres passe-bandes 6 et 7 sont constitués de résonateurs à ligne, il existe des résonances parasites à des fréquences supérieures à la fréquence d'accord. Dans le cas d'un résonateur constitué d'une ligne quart-d'onde non raccourcie, la fréquence de résonance parasite la plus proche est égale à trois fois la fréquence d'accord. Dans le cas d'une ligne demi-onde, la fréquence de résonance parasite la plus proche est égale à deux fois la fréquence d'accord. Dans le cas d'une ligne quartd'onde raccourcie, dans la proportion x, et accordée par une capacité ajustable située à son extrémité, la fréquence de résonance parasite la plus proche est égale

$$\frac{3F_o}{x}.$$

Pour éviter que ces résonances parasites perturbent la réception à certaines fréquences du domaine de fréquences considéré, un remède simple consiste à prévoir un filtre passe-bas en série avec chacun des filtres passe-bandes 6 et 7.

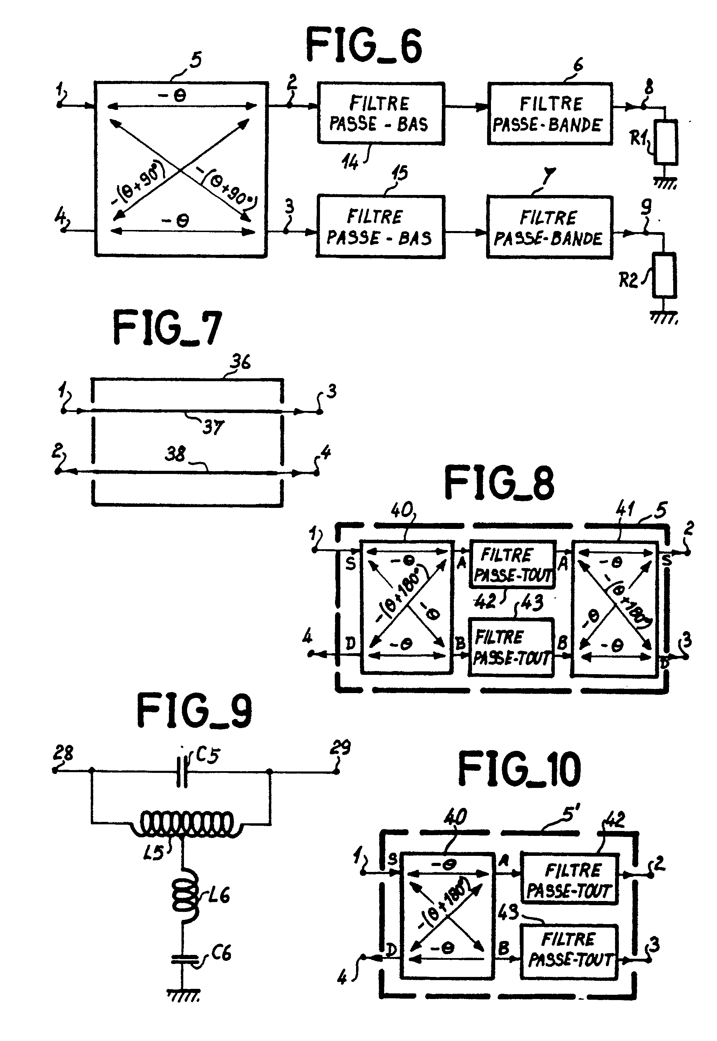

La figure 6 représente le schéma synoptique d'un second mode de réalisation du réjecteur de bande selon l'invention, comportant, en plus des éléments du premier mode de réalisation représentée sur la figure 3, un filtre passe-bas 14 intercalé entre la borne de sortie 2 du coupleur 5 et l'entrée du filtre 6, et comportant un filtre passe-bas 15 intercalé entre la borne de sortie 3 du coupleur 5 et l'entrée du filtre passe-bande 7. Ils ont une fréquence de coupure légèrement supérieure à la fréquence $F_o$. Ils peuvent être constitués par exemple d'un filtre en pi comportant une inductance en série entre l'entrée et la sortie du filtre passe-bas et deux capacités reliées au potentiel de référence. Ces filtres passe-bas empêchent les filtres passe-bandes 6 et 7 de présenter une impédance adaptée à l'impédance du second accès et du troisième accès du coupleur 5, pour les fréquences de résonance parasite des filtres 6 et 7.

Plusieurs types de coupleur quadrature -3dB peuvent être employés, selon le domaine de fréquences à couvrir. Dans tous les cas il doit être d'un type permettant un fonctionnement dans un très large domaine de fréquences. Pour des fréquences supérieures à 50 MHz, un type préférentiel est connu sous le nom de coupleur "BACKWARD", dont un exemple de réalisation est représentée sur la figure 7. Ce coupleur comporte un boîtier métallique 36 contenant deux lignes parallèles couplées, 37 et 38, dont la longueur correspond à un quart d'onde. Les extrémités de la ligne 37, par exemple, constituent respectivement le premier et le troisième accès du coupleur, alors que les extrémités de la ligne 38 constituent respectivement le second et le quatrième accès du coupleur, le premier et le second accès du coupleur étant situés aux extrémités des lignes 37 et 38 en vis-à-vis, alors que le troisième et la quatrième accès sont constitués par les deux autres extrémités des lignes 37 et 38.

Il existe d'autres modes connus de réalisation d'un coupleur "BACKWARD", comportant un nombre impair de lignes quart d'onde. Par exemple un coupleur "BACKWARD" comportant trois tronçons de ligne quart-d'onde permet d'obtenir la couverture d'un domaine de fréquences dont la fréquence maximale et la fréquence minimale sont dans un rapport supérieur à 5. Un coupleur "BACKWARD" comportant cinq tronçons de ligne quart-d'onde permet d'obtenir la couvertude d'un domaine de fréquences dont la fréquence maximale et la fréquence minimale ont un rapport supérieur à 15.

Pour le domaine des fréquences inférieures à 150 MHz il est possible d'utiliser un coupleur classique à constantes localisées. La figure 8 représente le schéma synoptique d'un tel coupleur comportant : un premier et un second coupleur hybride, 40 et 41, et comportant deux filtres passe tout, 42 et 43. Chaque coupleur hybride comporte quatre accès tels que si un signal est appliqué sur le premier accès, noté S, deux signaux ayant un même déphasage de valeur -θ sont obtenus sur le second et le troisième accès, notés A et B, et un signal d'amplitude nulle est obtenu sur le quatrième accès, notés D. Inversement, si un signal est appliqué en D, deux signaux en opposition de phase sont obtenus sur A et B, leurs déphasages par rapport au signal en D étant respectivement -θ -180° et -θ ; et un signal d'amplitude nulle est obtenu sur l'accès S. Ces propriétés ne sont vérifiées que si les quatre accès sont reliés à des impédances adaptées.

Dans l'exemple de réalisation représentée sur la figure 8, le premier accès S du coupleur hybride 40 constitue le premier accès du coupleur 5. Le quatrième accès D du coupleur hybride 40 constitue le quatrième accès du coupleur 5. Le second accès, A, et le troisième accès, B, du coupleur 40 sont reliés respectivement à une entrée du filtre 42 et à une entrée du filtre 43. Le second accès, A, et le troisième accès, B, du coupleur hybride 41 sont reliés respectivement à une sortie du filtre 42 et à une sortie du filtre 43. Le premier accès, S, et le second accès, D, du coupleur hybride 41 constituent respectivement le second et le troisième accès du coupleur 5.

5

Les filtres passe-tout 42 et 43 sont du deuxième ordre. Leur schéma est représenté sur la figure 9. Il comporte une borne d'entrée 28 et une borne de sortie 29 entre lesquelles est intercalé un circuit antirésonnant constitué d'une inductance L5 et d'une capacité C5 en parallèle. L'inductance L5 comporte une prise médiane reliée au potentiel de référence par l'intermédiaire d'un autre circuit résonnant constitué d'une inductance L6 et d'une capacité C6 en série. Les valeurs de ces capacités et de ces inductances sont calculées selon des formules très classiques, et sont telles que les filtres passe-tout 42 et 43 procurent une différence de phase, l'un par rapport à l'autre, égale à 90° dans tout le domaine de fréquences considérées. Avec de tels filtres passe-tout du deuxième ordre une différence de phase de 90° peut être obtenue avec une incertitude de ± 2° dans un large domaine de fréquences, le rapport entre la fréquence maximale et la fréquence minimale pouvant atteindre 8.

Si un signal de valeur V1 est appliqué à l'accès 1 et si $\alpha$ et $\beta$ sont respectivement les déphasages réalisés par les filtres passe-tout 42 et 43, les accès 2, 3, 4 du coupleur 5 ainsi constitué fournissent des signaux qui ont respectivement les valeurs suivantes :

$$V2 = \frac{V1}{\sqrt{2}}.e^{-j(2\theta + \alpha + \frac{\pi}{4})}$$

$$V3 = \frac{V1}{\sqrt{2}}.e^{-j(2\theta + \beta + \frac{\pi}{4})}$$

$$V4 = 0$$

Dans ces formules les pertes de coupleurs sont négligées.

La différence $\alpha - \beta$ étant égale à $\frac{\pi}{2}$, il apparaît que les signaux V3 et V2 sont en quadrature.

Réciproquement, si un signal de valeur V4 est appliqué sur l'accès 4 du coupleur 5 ainsi constitué, les accès 2 et 3 fournissent des signaux qui ont respectivement pour valeurs :

$$V2 = \frac{V4}{\sqrt{2}}.e^{-j(2\theta + \beta + \frac{\pi}{4})}$$

$$V3 = \frac{V4}{\sqrt{2}}.e^{-j(2\theta + \alpha + \frac{\pi}{4})}$$

Il apparaît que ces signaux sont aussi en quadrature. Le coupleur 5 ainsi constitué est donc bien équivalent à un coupleur en quadrature. De tels coupleurs sont disponibles, tout faits, dans le commerce, pour certaines grammes de fréquence.

Dans le cas où un tel coupleur n'est pas acheté tout fait, il est possible de le réaliser en le simplifiant. En effet, dans cette application, il n'est pas nécessaire que le coupleur quadrature utilisé ait la propriété de réciprocité. Ceci permet de supprimer le coupleur hybride 41, sans affecter le fonctionnement du réjecteur de bande.

La figure 10 représente le schéma synoptique d'un coupleur 5' selon ce mode de réalisation simplifiée, où la sortie du filtre passe-tout 42 constitue le second accès du coupleur 5' et où la sortie du filtre passe-tout 43 constitue le troisième accès du coupleur 5'.

Si un signal de valeur V1 est appliqué sur l'accès 1 de ce coupleur 5', et si on néglige les pertes d'insertion du coupleur hybride 40, les accès 2, 3, 4 fournissent respectivement des signaux de valeur :

$$V2 = \frac{V1}{\sqrt{2}}.e^{-j(\theta + \alpha)}$$

$$V3 = \frac{V1}{\sqrt{2}}.e^{-j(\theta + \beta)}$$

$$V4 = 0$$

Le signal fourni par l'accès 3 est donc déphasé de $-\frac{\pi}{2}$ par rapport au signal fournit par l'accès 2.

Les accès 2 et 3 sont chargés par les filtres passe-bande 6 et 7 conformément au schéma de la figure 3. Si ces filtres passe-bande 6 et 7 sont chargés par des impédances adaptées, ils présentent un coefficient de réflexion $\rho(f) = \Gamma(f).e^{-j.\psi(f)}$, où f est la fréquence.

Si un signal de valeur V1 est appliqué sur l'accès 1, les signaux aux bornes des résistances R1 et R2 ont respectivement pour valeur :

$$V_{R2} = (1 - \rho).\frac{V1}{\sqrt{2}}.e^{-j(\theta + \alpha + \psi)}$$
$$V_{R3} = (1 - \rho).\frac{V1}{\sqrt{2}}.e^{-j(\theta + \beta + \psi)}$$

L'accès 4 fournit alors un signal de valeur :

$$V4 = \frac{V1}{\sqrt{2}}.\left[e^{-j(\theta + 2\alpha + \psi + \pi)} + e^{-j(\theta + 2\beta + \psi)}\right]$$

$\alpha$ étant égal à $\beta - \frac{\pi}{2}$, V4 est encore égal à :

$$V4 = \rho.V1.e^{-j(\theta + \psi + 2\beta)}$$

Pour la fréquence d'accord des filtres 6 et 7, le coefficient de réflexion $\rho$ est nul, donc V4 est nul.

Hors de la fréquence d'accord, le coefficient de réflexion $\rho$ est égal à ± 1, donc $V4 = V1.e^{-j(\theta + \psi + 2\beta)}$. Donc le réjecteur selon l'invention fonctionne aussi avec un coupleur quadrature simplifié, non réciproque, conforme au schéma de la figure 10.

La figure 11 représente le schéma synoptique d'une station de réception radio comportant une pluralité de récepteurs radio 54,...,56 utilisant une antenne commune 49 et des réjecteurs communs 50, 51, 52. L'antenne 49 est reliée à l'entrée d'un premier réjecteur 50, rejetant une fréquence $F_0$. Une sortie du réjecteur 50 est reliée à une entrée d'un second réjecteur, 51, rejetant une fréquence $F_1$. Une sortie du réjecteur 51 est reliée à une entrée d'un troisième réjecteur 52, rejetant une fréquence $F_2$. Une sortie du réjecteur 52 est reliée à une entrée d'un multi-coupleur 53 possédant une pluralité de sorties reliées respectivement aux entrées des récepteurs radio 54 à 56. Les réjecteurs 50, 51, 52 sont donc reliés en série pour rejeter trois fréquences brouilleuses.

Comme il a été mentionné précédemment, les réjecteurs selon l'invention ont la propriété d'avoir une entrée et une sortie qui restent adaptées pour toutes les fréquences, ce qui permet cette mise en série sans problème. La perte d'insertion, hors la bande rejetée, est faible, de l'ordre de 0,2 dB à 0,3 dB pour chaque réjecteur de bande. Elle est égale au double de la perte d'insertion des coupleurs en quadrature -3dB, qui est très faible. La perte d'insertion des filtres passe-bandes à la fréquence d'accord est sans incidence sur la transmission du réjecteur.

La réponse du réjecteur suit la loi donnée par la formule 3, cependant, à cause des imperfections des coupleurs quadratures -3dB, la réjection n'est pas infinie. Dans un exemple de réalisation comportant un coupleur backward, utilisé dans la gamme de 90 à 550 MHz, et ayant une directivité ne dépassant 20 dB, la réjection obtenue est de 25 dB. La directivité du coupleur limite la valeur de la réjection obtenue. Il a été vérifié qu'il est possible d'obtenir une réjection supérieure de 10 à 15 dB à la valeur de la directivité du coupleur, en réalisant une légère retouche de l'accord des filtres passe-bandes, mais cette retouche provoque une détérioration de l'adaptation d'impédance du réjecteur. Dans cet exemple de réalisation, et en l'absence de retouche de l'accord, un taux d'onde stationnaire de l'ordre de 1,2 est obtenu dans toute la gamme de fréquences.

L'invention ne se limite pas aux exemples de réalisations décrits précédemment, puisque de nombreux autres modes de réalisations des coupleurs quadratures -3dB et des filtres passe-bandes sont connus.

L'invention est applicable notamment aux récepteurs radio à très larges gammes pour la surveillance radioélectrique.

## Revendications

**1.** Réjecteur de bande à grande sélectivité, pour transmettre toutes les fréquences d'un domaine de fréquences déterminé et rejeter une étroite bande centrée sur une fréquence $F_o$ déterminée, caractérisé en ce qu'il comporte :
- un coupleur (5) dit coupleur quadrature à -3dB, ayant un premier accès (1) constituant l'entrée du réjecteur, un second accès (2), un troisième accès (3), et un quatrième accès (4) consitutant une sortie du réjecteur, et tels que si un signal est appliqué au premier accès (1), le second et le troisième accès (2, 3) fournissent respectivement deux signaux d'amplitudes égales et en quadrature, et le quatrième accès fournit un signal d'amplitude nulle si et seulement si le second et le troisième accès sont chargés par des impédances adaptées ;
- un premier et un second filtre passe-bande (6 et 7) identiques, à haute sélectivité, accordés sur la fréquence $F_o$, ayant chacun une entrée dont l'impédance est adaptée à celle du coupleur pour la fréquence $F_o$, étant couplés respectivement au second et au troisième accès (2, 3) du coupleur en quadrature (5) et ayant chacun une sortie (8 et 9) chargée par une impédance (R1, R2) adaptée pour la fréquence Fo.

2. Réjecteur selon la revendication 1, caractérisé en ce que le coupleur quadrature à -3dB (5) comporte :
- un coupleur (40) dit coupleur hybride, ayant un premier, un second, un troisième, et un quatrième accès tels que si un signal est appliqué sur le premier accès (S), deux signaux en phase, entre eux, sont obtenues respectivement sur le second et le troisième accès (A et B) et un signal d'amplitude nulle est obtenu sur le quatrième accès (D) si et seulement si les quatre accès sont reliés à des impédances adaptées, le premier et le quatrième accès (S et D) constituant le premier et le second accès du coupleur en quadrature (5) ;
- un premier et un second filtre passe-tout (42, 43) tels que si un même signal traverse ces deux filtres il est restitué par ces deux filtres avec un écart de phase de 90° constant dans tout le domaine de fréquences considéré, une entrée du premier filtre passe-tout (42) étant reliée au second accès (A) du coupleur hybride (40) et sa sortie étant couplée au second accès (2) du coupleur en quadrature (5), une entrée du second filtre passe-tout (43) étant reliée au troisième accès (B) du coupleur hybride (40) et sa sortie étant couplée au troisième accès du coupleur en quadrature (5').

3. Réjecteur selon la revendication 2, caractérisé en ce qu'il comporte en outre un second coupleur hybride (41) analogue au premier (40), pour coupler les sorties des deux filtres passe-tout (42, 43) aux sorties (2, 3) du coupleur en quadrature (5), son troisième et son quatrième accès (A et B) étant reliés respectivement aux sorties du premier et du second filtre passe-tout (42, 43), son premier et son second accès (S et D) étant reliés respectivement au second et au troisième accès du coupleur en quadrature (5).

4. Réjecteur selon l'une des revendications 1 à 5, caractérisé en ce que le coupleur en quadrature à -3dB est constitué d'un coupleur du type "BACKWARD" comportant deux ou un nombre impair de lignes quart d'onde (37, 38) couplées électromagnétiquement.

5. Réjecteur selon l'une quelconque des revendications 1 à 4, caractérisé en ce qu'il comporte en outre deux filtres passe-bas (14, 15) couplant respectivement le second et le troisième accès (2, 3) du coupleur en quadrature (5) aux entrées du premier et du second filtre passe-bande (6, 7), la fréquence de coupure des deux filtres passe-bas (14, 15) étant supérieure ou égale à la fréquence maximale du domaine de fréquences considéré.

6. Utilisation d'au moins un réjecteur selon l'une quelconque des revendications 1 à 5, dans une station de réception radio comportant au moins un récepteur radio (54 à 56), chaque réjecteur étant intercalé en série entre une antenne (49) et une entrée de chaque récepteur (54 à 56).

## Claims

1. A highly selective band trap for transmitting all the frequencies of a predetermined frequency range and for rejecting a small band centered at a predetermined frequency $F_o$, characterized in that it comprises:
- a coupler (5) referred to as quadrature coupler at -3dB, having a first access (1) which constitutes the input of the trap, a second access (2), a third access (3) and a fourth access (4) which constitutes a trap output in such a way that, if a signal is applied to the first access (1), the second access (2) and the third access (3) supply respectively two signals of equal amplitude and in quadrature relationship, whereas the fourth access supplies a signal of amplitude zero if, and only if, the second access and the third access are charged by matched impedances,
- first and second identical bandpass filters (6 and 7) of high selectivity, these filters being tuned to the frequency $F_o$ and providing each an input whose impedance is matched to that of the coupler for the frequency $F_o$, the filters being respectively coupled to the second access (2) and the third access (3) of the quadrature coupler (5) and providing each an output (8 and 9) charged by an impedance (R1, R2) which is matched for the frequency $F_o$.

2. A trap according to claim 1, characterized in that the quadrature coupler at -3dB (5) comprises:
- a coupler (40) referred to as hybrid coupler and having first, second, third and a fourth accesses such that if a signal is applied to the first access (S), two signals of equal phase are obtained on the second and the third access (A and B), and a signal of amplitude zero is obtained on the fourth access (D) if, and only if, the four accesses are connected to matched impedances, the first and the fourth access (S and D) constituting the first and second access of the quadrature coupler (5),
- a first and a second pass filter (42, 43) such that if the same signal is applied to the two filters, they supply signals which have a constant phase shift of 90° over the entire considered frequency range, an input of the first pass filter (42) being connected to a second access (A) of the hybrid coupler (40) and its output being coupled to a second access (2) of the quadrature coupler (5'), an input of the second pass filter (43) being connected to the third access (B) of the hybrid coupler (40) and its output being coupled to a third access of the quadrature coupler (5').

3. A trap according to claim 2, characterized in that it further comprises a second hybrid coupler (41) similar to the first one (40) for coupling the outputs of the two pass filters (42, 43) to the outputs (2, 3) of the quadrature coupler (5), its third and fourth accesses (A and B) being respectively connected to the output of the first and the output of the second pass filter (42, 43), its first and second accesses (S and D) being respectively connected to the second access and the third access of the quadrature coupler (5).

4. A trap according to one of claims 1 to 3, characterized in that the quadrature coupler at -3dB is constituted by a BACKWARD type coupler which comprises two or an odd number of quarter wavelength lines (37, 38) which are electromagnetically coupled.

5. A trap according to any one of claims 1 to 4, characterized in that it further comprises two lowpass filters (14, 15) which couple respectively the second and third access (2, 3) of the quadrature coupler (5) to the inputs of the first and second bandpass filter (6, 7), the cut-off frequency of the two lowpass filters (14, 15) being at least equal to the highest frequency of the considered frequency range.

6. The use of at least one trap according to any one of claims 1 to 5 in a radio reception station comprising at least one radio receiver (54 to 56), each trap being inserted in series between an antenna (49) and an input of each receiver (54 to 56).

**Patentansprüche**

1. Hochselektiver Bandsperrkreis zur Übertragung aller Frequenzen eines bestimmten Frequenzbands und zur Blockierung eines schmalen Frequenzbands, das um eine bestimmte Frequenz $F_o$ zentriert ist, dadurch gekennzeichnet, daß er aufweist:
- einen Koppler (5), Quadraturkoppler bei -3dB genannt, mit einem ersten Anschluß (1), der den Eingang des Sperrkreises bildet, einem zweiten Anschluß (2), einem dritten Anschluß (3) und einem vierten Anschluß (4), der einen Ausgang des Sperrkreises bildet, derart, daß, wenn ein Signal an den ersten Anschluß (1) gelangt, der zweite und der dritte Anschluß (2, 3) zwei einander amplitudengleiche und in Quadratur liegende Signale liefern, während der vierte Anschluß ein Signal der Amplitude Null dann und nur dann liefert, wenn der zweite und der dritte Anschluß mit angepaßten Impedanzen belastet sind,
- zwei hochselektive und einander gleiche Bandpaßfilter (6 und 7), die auf die Frequenz $F_o$ abgestimmt sind und je einen Eingang besitzen, dessen Impedanz an die des Kopplers für die Frequenz $F_o$ angepaßt ist, wobei die beiden Filter an den zweiten bzw. dritten Anschluß (2, 3) des Quadraturkopplers (5) gekoppelt sind und je einen Ausgang (8 und 9) besitzen, der durch eine für

die Frequenz $F_0$ angepaßte Impedanz (R1, R2) belastet ist.

2. Sperrkreis nach Anspruch 1, dadurch gekennzeichnet, daß der Quadraturkoppler bei -3dB (5) aufweist:
   - einen Hybridkoppler genannten Koppler (40) mit einem ersten, zweiten, dritten und vierten Anschluß, derart, daß, wenn ein Signal an den ersten Anschluß (S) gelangt, zwei einander phasengleiche Signale am zweiten und am dritten Anschluß (A und B) auftreten und ein Signal der Amplitude Null am vierten Anschluß (D) dann und nur dann auftritt, wenn die vier Anschlüsse mit angepaßten Impedanzen verbunden sind, wobei der erste und der vierte Anschluß (S und D) den ersten und zweiten Anschluß des Quadraturkopplers (5) bilden,
   - ein erstes und zweites Durchlaßfilter (42, 43), derart, daß, wenn ein gleiches Signal die beiden Filter durchquert, dieses Signal von den beiden Filtern mit einer Phasenverschiebung von 90° abgegeben wird, die im ganzen betrachteten Frequenzbereich konstant ist, wobei ein Eingang des ersten Durchlaßfilters (42) an den zweiten Anschluß (A) des Hybridkopplers (40) und sein Ausgang an den zweiten Anschluß (2) des Quadraturkopplers (5') angeschlossen ist, während ein Eingang des zweiten Durchlaßfilters (43) mit einem dritten Anschluß (B) des Hybridkopplers (40) und sein Ausgang mit dem dritten Anschluß des Quadraturkopplers (5') verbunden ist.

3. Sperrkreis nach Anspruch 2, dadurch gekennzeichnet, daß er außerdem einen zweiten Hybridkoppler (41) besitzt, der dem ersten Koppler (40) gleicht, um die Ausgänge der beiden Durchlaßfilter (22, 43) mit den Ausgängen (2, 3) des Quadraturkopplers (5) zu verbinden, wobei der dritte und der vierte Anschluß (A und B) dieses Hybridkopplers an den Ausgang des ersten bzw. zweiten Durchlaßfilters (42, 43) und sein erster und zweiter Anschluß (S und D) an den zweiten bzw. dritten Anschluß des Quadraturkopplers (5) angeschlossen sind.

4. Sperrkreis nach einem der Ansprüche 1 bis 5, dadurch gekennzeichnet, daß der Quadraturkoppler aus einem "BACKWARD"-Koppler besteht, der zwei oder eine ungerade Anzahl von elektromagnetisch gekoppelten Viertelwellenleitungen (37, 38) besitzt.

5. Sperrkreis nach einem beliebigen der Ansprüche 1 bis 4, dadurch gekennzeichnet, daß er außerdem zwei Tiefpaßfilter (14, 15) aufweist, die den zweiten und dritten Anschluß (2, 3) des Quadraturkopplers (5) mit den Eingängen des ersten und zweiten Bandpaßfilters (6, 7) koppeln, wobei die Grenzfrequenz der beiden Tiefpaßfilter (14, 15) mindestens der höchsten Frequenz des betrachteten Frequenzbereichs gleicht.

6. Verwendung mindestens eines Sperrkreises nach einem beliebigen der Ansprüche 1 bis 5 in einer Funkempfangsstation mit mindestens einem Funkempfänger (54 bis 56), wobei jeder Sperrkreis in Reihe zwischen einer Antenne (49) und einem Eingang jedes Empfängers (54 bis 56) eingefügt ist.

# FIG_1

# FIG_2

# FIG_3

# FIG_4

# FIG_5

# FIG_6

# FIG_7

# FIG_8

# FIG_9

# FIG_10

# FIG_11